(19) Europäisches Patentamt

European Patent Office

Office européen des brevets

(11) **EP 1 157 423 B1**

(12) **EUROPÄISCHE PATENTSCHRIFT**

(45) Veröffentlichungstag und Bekanntmachung des Hinweises auf die Patenterteilung:
**27.09.2006 Patentblatt 2006/39**

(21) Anmeldenummer: **00915110.1**

(22) Anmeldetag: **23.02.2000**

(51) Int Cl.:
*H01L 27/144* (2006.01)     *H01L 27/146* (2006.01)

(86) Internationale Anmeldenummer:
**PCT/DE2000/000500**

(87) Internationale Veröffentlichungsnummer:
**WO 2000/051185 (31.08.2000 Gazette 2000/35)**

(54) **BILDZELLE**

IMAGE CELL

CELLULE VIDEO

(84) Benannte Vertragsstaaten:
**DE FR IT**

(30) Priorität: **24.02.1999 DE 19907972**

(43) Veröffentlichungstag der Anmeldung:
**28.11.2001 Patentblatt 2001/48**

(73) Patentinhaber: **ROBERT BOSCH GMBH**
**70442 Stuttgart (DE)**

(72) Erfinder:
• **HENNO, Christiane**
**D-72070 Tübingen (DE)**
• **BAUER, Roger**
**D-72762 Reutlingen (DE)**
• **METTLER, Stephan**
**D-72766 Reutlingen (DE)**
• **COCHARD, Roland**
**CH-1110 Morges (CH)**
• **DEBIEUX, Stéphane**
**CH-1203 Genève (CH)**
• **OSSEIRAN, Adam**
**CH-1028 Préverenges (CH)**

(56) Entgegenhaltungen:
**EP-A- 0 469 878          DE-A- 4 209 536**

• **RICQUIER N ET AL: "RANDOM ADDRESSABLE CMOS IMAGE SENSOR FOR INDUSTRIAL APPLICATIONS" SENSORS AND ACTUATORS A, CH,ELSEVIER SEQUOIA S.A., LAUSANNE, Bd. A44, Nr. 1, 1. Juli 1994 (1994-07-01), Seiten 29-35, XP000469151 ISSN: 0924-4247**
• **PATENT ABSTRACTS OF JAPAN vol. 008, no. 265 (P-318), 5. Dezember 1984 (1984-12-05) & JP 59 133439 A (MITSUBISHI DENKI KK), 31. Juli 1984 (1984-07-31)**
• **TU N ET AL: "CMOS active pixel image sensor with combined linear and logarithmic mode operation" CONFERENCE PROCEEDINGS. IEEE CANADIAN CONFERENCE ON ELECTRICAL AND COMPUTER ENGINEERING (CAT. NO. 98TH8341), CONFERENCE PROCEEDINGS. IEEE CANADIAN CONFERENCE ON ELECTRICAL AND COMPUTER ENGINEERING, WATERLOO, ONT., CANADA, 24-28 MAY 1998, Seiten 754-757 vol.2, XP002143093 1998, New York, NY, USA, IEEE, USA ISBN: 0-7803-4314-X**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Bildsensor mit einer Mehrzahl optoelektronischer Bildzeller, wobei die Bildzellen ein einen Fotostrom abgebendes lichtempfindliches Element und einem Impedanzwandler für den Fotostrom umfassen. Derartige Bildzellen, deren licht-empfindliche Elemente insbesondere großflächige Grenzschichten in einem Halbleitersubstrat sind, sind aus zahlreichen Anmeldungen wie zum Beispiel DE 42 09 536 C2, US 4 973 833 oder EP 390 205 bekannt.

Die Entstehung eines Fotostroms in einem solchen lichtempfindlichen Element ist zurückzuführen auf durch Lichteinfall induzierte Erzeugung von Elektronen-Loch-Paaren in der Raumladungszone des Halbleitermaterials , wobei die Elektronen und Löcher unter dem Einfluß der dort wirksamen elektrischen Felder auseinanderdriften und in Form eines Fotostroms von dem lichtempfindlichen Element abgegriffen werden können. Durch Anlegen einer Spannung von mehreren Volt in Sperrichtung an eine solche Halbleitergrenzschicht lassen sich Lichtsignale mit einer Reaktionszeit von im Pikosekundenbereich nachweisen, doch ist der Dynamikbereich eines in dieser Weise betriebenen lichtempfindlichen Elements, das heißt das Verhältnis zwischen der größten und der kleinsten Belichtungsleistung, bei denen das Ver-hältnis zwischen Lichteinfall und Signal im wesentlichen linear ist, zu klein, als daß es für Bilderfassungsanwendungen, insbesondere im Automotivbereich, anwendbar wäre. Bei derartigen Anwendungen, zum Beispiel Auffahr-Warn- oder -Schutzsystemen muß ein bildverarbeitendes System in der Lage sein, Bilder korrekt zu erfassen und zu verarbeiten, bei denen sich die Helligkeit einzelner Bildpunkte um etliche Zehnerpotenzen unterscheidet. So darf sich das Bilderfassungssystem beispielsweise nicht von Sonnenlichtreflexen an einem vorausfahrenden Fahrzeug oder, bei Nachtfahrten, von den Scheinwerfern des entgegenkommenden Verkehrs blenden lassen, und es muß in der Lage sein, beim Fahren durch einen Tunnel die Silhouette eines vor der Tunnelmündung von der Sonne beschienenen Fahrzeugs zu erfassen. Gleichzeitig werden hohe Bildwiederholraten benötigt, um zum Beispiel Auffahr-Schutzsysteme mit einer deutlich kürzeren Reaktionszeit als der des Menschen realisieren zu können, die in der Lage sind, Auffahrunfälle auch bei zügiger Fahrt in einer dichtgedrängten Kolonne sicher auszuschließen.

Aus der US 4,876,534 ist bekannt, einen Ausgang eines Prozessors an einen invertierenden Eingang eines Operationsverstärkers anzuschließen, wobei eine nichtlineare Rückkopplungsschaltung vorgesehen ist. Die US 5,763,909 offenbart ein Bilderzeugungssystem mit einem großen Dynamikumfang.

Vorteile der Erfindung

Gemäß der Erfindung ist ein Rückkopplungselement zwischen dem Ausgang des Impedanzwandlers und dem lichtempfindlichen Element vorgesehen wobei der Bildsensor eine Bildzelle mit einem Impedanzwandler und einem Rückkoplungselement umfaßt, die an eine Stromquelle angeschlossen sind, die ausgelegt ist, um den Impedanzwandler zu sättigen. Es ist möglich, die Einschwingzeit, die die optoelektronische Bildzelle benötigt, um sich auf veränderte Lichtverhältnisse einzustellen, deutlich zu verkürzen und insbesondere den sogenannten Nachzieheffekt weitgehend zu unterdrücken, der sich bei herkömmlichen Systemen durch ein über mehrere Bildwiederholzyklen anhaltendes Nachleuchten eines einmal übersteuerten lichtempfindlichen Elements bemerkbar machen kann. Im Falle einer Änderung der Beleuchtungsstärke an dem lichtempfindlichen Element, die zu einer Veränderung der Spannung zwischen dessen Anschlüssen führt, kann bei der erfindungsgemäßen Bildzelle nämlich zum Einstellen der veränderten Spannung zusätzlich zu dem relativ geringen Fotostrom der über das Rückkopplungselement rückgeführte Anteil des Ausgangsstroms des Impedanzwandlers herangezogen werden, wodurch das lichtempfindliche Element in der Lage ist, Beleuchtungsänderungen wesentlich schneller als bisher zu folgen.

Dabei ist bevorzugtermaßen das Rückkopplungselement so ausgelegt, daß es die Potentiale an den Anschlüssen des lichtempfindlichen Elements auf einem von der Beleuchtungsstärke unabhängigen Wert hält. Da in diesem Fall bei einer Änderung der Beleuchtungsstärke keine Kapazitäten umgeladen werden müssen, kann nämlich der Fotostrom des lichtempfindlichen Elements und damit das vom Impedanzwandler ausgegebene Signal der Beleuchtungsstärke unabhängig von der Kapazität der Grenzschicht schnell folgen; die Reaktionszeit der Bildzelle ist praktisch lediglich durch die Reaktionszeit des Impedanzwandlers beziehungsweise des lichtempfindlichen Elements beschränkt.

Als Rückkopplungselement wird insbesondere bei der Realisierung der Bildzelle als integrierte Schaltung zweckmäßigerweise ein MOS-Transistor verwendet.

Dieser MOS-Transistor ist vorzugsweise in schwacher Inversion betrieben. Die Gate-Source-Spannung eines solchen Transistors ist über bis zu 8 Dekaden hinweg dem Logarithmus seines Drainstroms proportional. Durch Verwendung eines solchen Transistors als ein Rückkopplungselement mit logarithmischer Strom-Spannungskennlinie ist es möglich, die Dynamik des lichtempfindlichen Elements bei hohen Beleuchtungsstärken zu komprimieren, so daß die starken Helligkeitsunterschiede, die bei den oben erwähnten Anwendungen im Automotivbereich auftreten, zufriedenstellend aufgelöst werden können.

Das lichtempfindliche Element kann insbesondere eine Fotodiode sein.

Als Impedanzwandler kommt vorzugsweise ein Operationsverstärker mit einem mit dem lichtempfindlichen Element verbundenen invertierenden Eingang und einem mit einem Vorspannpotential verbundenen nichtinvertierenden Eingang in Betracht. Durch Vorgeben eines individuellen Vorspannpotentials am nicht invertierenden Eingang lassen sich fertigungsbedingte Streuungen im Verhalten einzelner Bildzellen kompensieren, was inbesondere dann von Interesse ist, wenn die Bildzelle gemeinsam mit anderen gleichartigen Bildzellen in einem Bildsensor integriert ist.

Der erfindungsgemäße Bildsensor umfaßt ferner zweckmäßigerweise auch ein gegen Lichteinfall abgeschirmtes lichtempfindliches Element. An diesem Element kann ein Dunkelstrom abgegriffen werden, der allein auf thermische Elektronen-Loch-Erzeugung zurückgeht. Dieser Dunkelstrom wird im Bildsensor zweckmäßigerweise in der gleichen Weise wie der Fotostrom einer belichteten Bildzelle mit einem Rückkopplungselement und einem Impedanzwandler verarbeitet. Dieses Ausgangssignal kann von dem Ausgangssignal einer belichteten optoelektronischen Bildzelle subtrahiert werden, um so das thermische Rauschen der Bildzellen im wesentlichen zu unterdrücken, oder es kann als Referenzpegel herangezogen werden.

Des weiteren sind ein Impedanzwandler und ein Rückkopplungselement vorgesehen, die anstatt an ein lichtempfindliches Element an eine Stromquelle angeschlossen sind, die ausgelegt ist, um den Impedanzwandler zu sättigen. Das Ausgangssignal dieses Impedanzwandlers kann dann als Referenz für das maximal erzielbare Ausgangssignal der Bildzelle dienen.

Weitere Merkmale und Vorteile der Erfindung ergeben sich aus der nachfolgenden Beschreibung eines Ausführungsbeispiels.

Es zeigen:

Figur 1          ein schematisches Blockschaltbild einer erfindungsgemäßen Bildzelle;

Figur 2          ein detailliertes Schaltbild einer erfindungsgemäßen Bildzelle;

Figur 3          einen versuchsaufbau zur Messung des Verhaltens der Bildzelle;

Figuren 4a und 4b    das von der Bildzelle gelieferte Ausgangssignal bei zwei verschiedenen Beleuchtungsleistungen;

Figur 5          eine typische Kennlinie der erfindungsgemäßen Bildzelle;

Figur 6          zum Vergleich das Ausgangssignal einer herkömmlichen Bildzelle;

Figur 7          das Schema eines Bildsensors gemäß der Erfindung;

Figur 8          eine Abwandlung der Bilzelle aus Figur 1; und

Figur 9          ein Diagramm.

Beschreibung der Ausführungsbeispiele

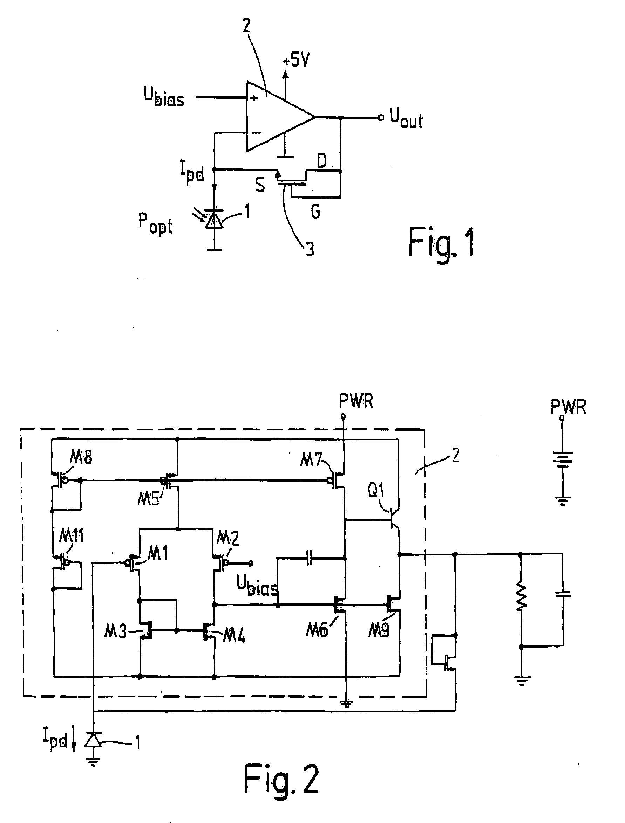

Figur 1 zeigt ein schematisches Schaltbild einer erfindungsgemäßen Bildzelle. Eine Fotodiode 1 ist einer Bestrahlungsleistung $P_{opt}$, die einen Fotostrom $I_{pd}$ in der Fotodiode hervorruft, ausgesetzt. Diese Fotodiode 1 ist zwischen Masse und den invertierenden Eingang eines Operationsverstärkers 2 geschaltet, an dessen nicht invertierendem Eingang ein Vorspannpotential $U_{bias}$ anliegt. Der Ausgang des Operationsverstärkers 2 bildet den Ausgang $U_{out}$ der Bildzelle und ist mit Gate und Drain eines MOS-Transistors 3 verbunden, dessen Source an den invertierenden Eingang des Operationsverstärkers 2 angeschlossen ist. Der MOS-Transistor 3 bildet so eine negative Rückkopplungsschleife am Operationsverstärker 2. Das Vorspannpotential $U_{bias}$ ist so gewählt, daß die Differenz zwischen der Ausgangsspannung $U_{out}$ des Operationsverstärkers 2 und der Spannung an dessen invertierendem Eingang kleiner als die thermodynamische Spannung Vth des MOS-Transistors 3 ist. Dieser arbeitet somit unter schwacher Inversion, das heißt seine Gate-Source-Spannung $U_{gs}$ ist zum Logarithmus des Drainstrom $I_d$ nach folgender Beziehung proportional.

$$V_{gs} = n \times U_t \times \ln(I_d/(I_{do} \times W/L)),$$

wobei $U_t$ die thermodynamische Spannung, n ein Steigerungsfaktor unter schwacher Inversion, W, L Abmessungen des Transistors und $I_{do}$ ein vom Fertigungsverfahren abhängiger Parameter sind.

Der Verstärkungsfaktor der Anordnung aus Operationsverstärker 2 und MOS-Transistor 3 ändert sich somit logarithmisch mit dem Photostrom $I_{pd}$ der Fotodiode, wodurch der Operationsverstärker in der Lage ist, Fotoströme zu verarbeiten, deren Stärke über mehrere Größenordnungen variiert.

Figur 2 zeigt detaillierter den Aufbau des Operationsverstärkers 2. Dieser enthält zwei Transistoren M8, M11, die zwischen einer Versorgungsspannung und Masse in Reihe geschaltet sind, um das Gatepotential von Transistoren M5 beziehungsweise M7 festzulegen, die jeweils eine Eingangs- beziehungsweise Ausgangsstufe des Operationsverstärkers mit Strom versorgen. Die Eingangsstufe umfaßt Transistoren M1 bis M4, wobei die Sources von M1 und M2 gemeinsam an den Drain von M5 angeschlossen sind und das Gate des Transistors M1 den invertierenden Eingang des Operationsverstärkers für den Fotostrom von der Fotodiode 1 bildet und das Gate von M2 den nichtinvertierenden Eingang für das Vorspannpotential $U_{bias}$ bildet. Die Transistoren M3 und M4 sind jeweils mit M1 beziehungsweise M2 in Reihe geschaltet, wobei die Gates von M3 und M4 an die Source des Transistors M1 angeschlossen sind.

Das zwischen der Source des Transistors M2 und dem Drain des Transistors M4 anstehende Potential wird abgegriffen und von der die Transistoren Q1, M6 und M9 umfassenden Ausgangsstufe weiter verstärkt.

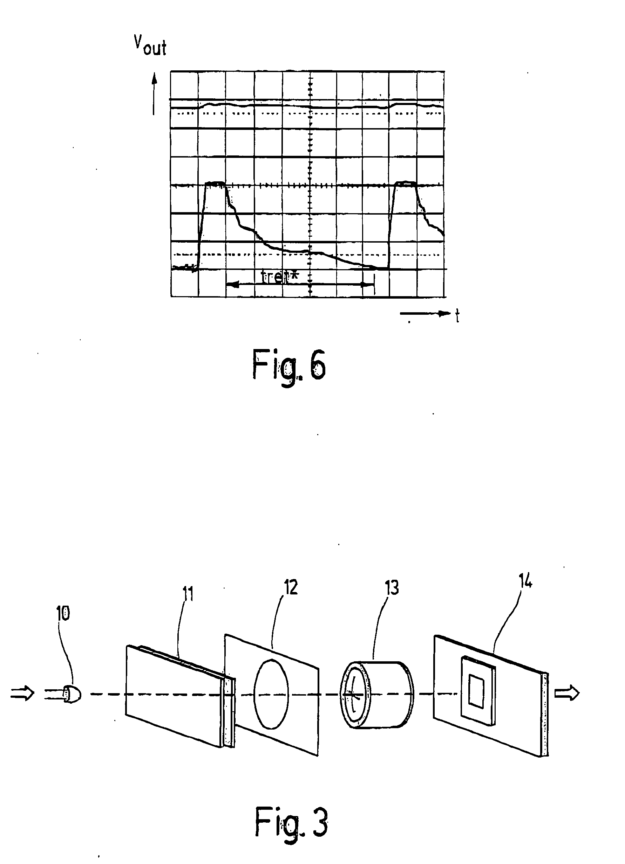

Figur 3 zeigt schematisch einen Versuchsaufbau, mit dem das Zeitverhalten der oben beschriebenen Bildzelle untersucht wurde. Der Aufbau umfaßt eine Hochleistungsleuchtdiode vom Typ Stanley ER-500L, die mit einem Rechteckstrom angesteuert wurde. Graukeile 11 dienten zur kontrollierten Abschwächung des Lichts der Leuchtdiode. Über eine Blende 12 und ein Objektiv 13 (Fujinon TV 1:1,4/16) wurde die Leuchtdiode 10 auf einen Bildsensor 14 abgebildet.

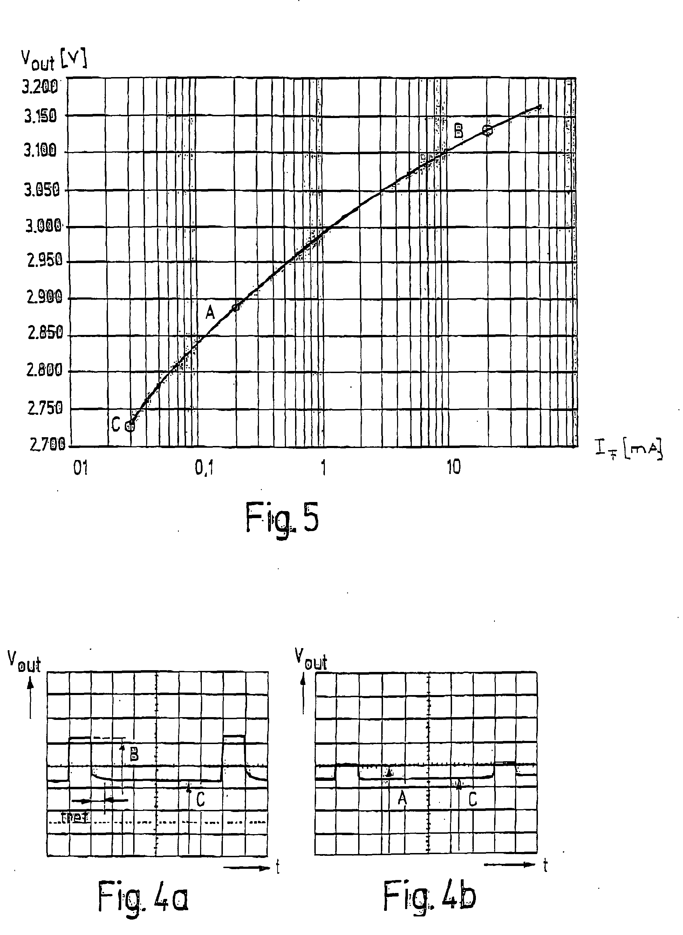

Figur 4a zeigt das Ausgangssignal einer Bildzelle für einen Rechteck-Ansteuerstrom der Leuchtdiode 10, bei dem sich Phasen mit hohem Ausgangssignal mit einer LED-Stromstärke von 20 mA und 50 ms Dauer (entsprechend der Niveaumarke B) und Phasen mit niedrigem Ausgangssignal mit einer LED-Stromstärke von 30 $\mu$A und 300 ms Dauer (entsprechend der Niveaumarke C) abwechseln. Der Übergang von niedrigem zu hohem Ausgangssignal erfolgt so schnell, daß er in der Zeichnung praktisch nicht aufgelöst ist.

Beim Rückgang der Beleuchtungsstärke nähert sich das Signal binnen weniger als 10 ms seinem neuen Wert (C) bis auf ca. 10 %, nach einer Abklingzeit $t_{ret}$ von ca. 30 ms ist der neue Pegel praktisch erreicht.

Ein ähnliches Verhalten zeigt Figur 4b, bei der der Rechteck-Ansteuerstrom zwischen 30 $\mu$A (Niveaumarke C) und 200 $\mu$A (Niveaumarke A) oszillierte . Die Abklingzeit ist hier eher noch kürzer als im Fall der Figur 4a.

Figur 5 zeigt das Verhältnis zwischen der Ausgangsspannung $V_{out}$ der Bildzelle und dem Erregungsstrom $I_p$ der Leuchtdiode 10 über den Regelbereich der Fotodiode von etwa 3 Dekaden. Dieser Erregungsstrom ist im dargestellten Bereich zur von der Bildzelle empfangenen optischen Leistung $P_{opt}$ linear proportional.

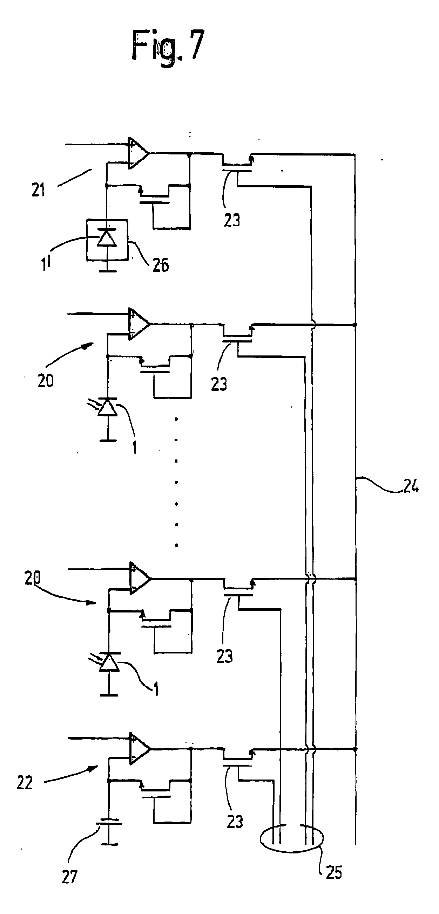

Figur 6 zeigt im Vergleich das zeitliche Verhalten des Ausgangssignals einer herkömmlichen Bildzelle ohne Rückkopplungselement, die mit der Versuchsanordnung aus Figur 3 untersucht wurde. Die Betriebsbedingungen der Fotodiode 10 waren die gleichen wie im Falle der Figur 4a. Wie man deutlich sieht, beträgt die Anstiegszeit des Ausgangssignals 10 ms, und der Abfall des Signals erstreckt sich über mehr als 250 ms. Die Abklingzeit ist also fast um einen Faktor 10 länger als bei der erfindungsgemäßen Bildzelle.

Figur 7 zeigt einen Bildsensor mit mehreren erfindungsgemäßen Bildzellen 20, die in Form einer Zeile auf einem gemeinsamen Substrat angeordnet sind, und deren Ausgänge jeweils über einen Schalttransistor 23 mit einer gemeinsamen Ausgangsleitung 24 verbindbar sind. Eine (nicht gezeigte) Steuerschaltung steuert über ein Bündel von Adressleitungen 25 jeweils einen der Schalttransistoren 23 an, um das Ausgangssignal der entsprechenden Bildzelle 20 auf die Ausgangsleitung 24 zu legen.

Vorzugsweise ist die Steuerschaltung auch dazu ausgelegt, an den nichtinvertierenden Eingang des Operationsverstärkers jeder Bildzelle das Vorspannpotential $U_{bias}$ anzulegen, wobei $U_{bias}$ für jede einzelne Bildzelle einen spezifischen Wert haben kann, der so gewählt ist, daß ein möglichst einheitliches Antwortverhalten der Bildzellen unter Ausgleich von fertigungsbedingten Streuungen erzielt wird. Die Auswahl und Einstellung der Vorspannpotentiale erfolgt zweckmäßigerweise bei der Herstellung des Bildsensors.

Am Ende der Zeile befinden sich zwei spezialisierte Bildzellen 21 beziehungsweise 22. Bei der Bildzelle 21 ist die Diode 1', die in ihren Abmessungen, Dotierungen und sonstigen für ihr Schaltverhalten maßgeblichen Eigenschaften nicht von den Fotodioden 1 der Bildzellen 20 unterscheidet, durch eine lichtundurchlässige Metallschicht auf der Oberfläche des Substrats überdeckt. Diese Metallschicht, die in der Figur als ein auf die Diode 1' beschränktes Quadrat 26 eingezeichnet ist, überdeckt in der Praxis zweckmäßigerweise auch die übrigen Schaltelemente der Bildzelle 21 sowie der anderen Bildzellen 20 und 22, um diese vor einer Beeinflussung ihrer Funktion durch Lichteinfall zu schützen. Die von der Bildzelle 21 gelieferte Ausgangsspannung, auch als Schwarzwert bezeichnet, entspricht somit, von fertigungsbedingten Streuungen zwischen den einzelnen Bildzellen abgesehen, der Ausgangsspannung, die eine Bildzelle 20 in unbelichtetem Zustand liefern würde. Sie definiert somit eine erste Grenze des Invervalls der möglichen Ausgangsspannnungen der Bildzellen, die bei der Auswertung der von den belichteten Bildzellen 20 gelieferten Signale herangezogen werden kann.

Bei der Bildzelle 22 ist die Fotodiode durch eine Stromquelle 27 ersetzt, die den Operationsverstärker 2 dieser Bildzelle in Sättigung gehen läßt. Das Ausgangssignal der Bildzelle 22, der sogenannte Weißwert, definiert somit die zweite Grenze des Invervalls der möglichen Ausgangsspannungen der Bildzellen 20. Diese Stromquelle kann zum Beispiel ein als Widerstand an ein Versorgungspotential geschalteter Transistor sein.

Da Schwarz- und Weißwert eventuellen Driften, insbesondere Temperaturdriften, der Bildzellen folgen, sind sie insbesondere nützlich, um bei der Auswertung der Ausgangssignale der normalen Bildzellen 20 deren Driftverhalten zu kompensieren.

Selbstverständlich ist die Erfindung auch anwendbar auf Bildsensoren mit mehreren Zeilen von Bildzellen. Dabei muß nicht jede Zeile eine oder beide spezialisierte Bildzellen 21 beziehungsweise 22 enthalten.

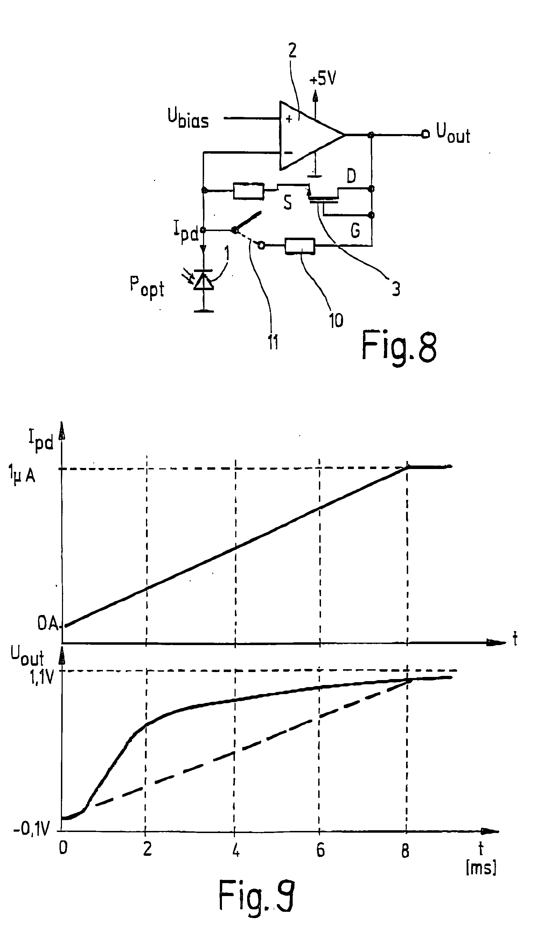

Figur 8 zeigt eine Abwandlung der Bildzelle aus Figur 1, bei der parallel zum MOOS-Transistor 3 ein Widerstand 10 und ein Schalter 11 in Reihe zwischen den Ausgang des Operationsverstärkers 2 und dessen invertierenden Eingang geschaltet sind. Im in Figur 9 dargestellten Zustand, in dem der Schalter 11 offen ist, verhält sich die Bildzelle wie die in Figur 1 gezeigte. Wenn der Schalter 11 geschlossen ist, bestimmt der Widerstand 10 das Verstärkungsverhalten des Operationsverstärkers 2, und die vom Operationsverstärker gelieferte Ausgangsspannung $U_{out}$ ist nicht mehr wie im Falle der Schaltung aus Figur 1 proportional zum Logarithmus des Photostroms $I_{pd}$, sondern folgt diesem linear.

Figur 9 verdeutlicht dieses Verhalten am Beispiel einer Photodiode, die mit einer Intensität beleuchtet wird, die zunächst während B ms linear zunimmt, dann 1 ms lang konstant bleibt. Der Photostrom $I_{pd}$ folgt dieser Intensität exakt proportional, das gleiche gilt für die Ausgangsspannung $U_{out}$ in dem Fall, daß der Schalter 11 geschlossen ist (gestrichelte Linie im unteren Diagramm von Figur 9.) Die durchgezogene Kurve zeigt die logarithmische Proportionalität der Ausgangsspannung $U_{out}$ zum Photostrom $I_{pd}$ im Falle, daß der Schalter 11 geöffnet ist.

**Patentansprüche**

1. Bildsensor mit einer Mehrzahl optoelektronischer Bildzellen , wobei die Bildzellen ein einen Fotostrom abgebendes lichtempfindliches Element (1;9) und einen Impedanzwandler (2) für den Fotostrom umfassen, wobei jeweils ein Rückkopplungselement (3;7) zwischen dem Ausgang des Impedanzwandlers (2) und einem Anschluß des lichtempfindlichen Elements (1;9) vorgesehen ist, **dadurch gekennzeichnet, daß** der Bildsensor eine Bildzelle (22) mit einem Impedanzwandler und einem Rückkopplungselement umfaßt, die an eine Stromquelle (27) angeschlossen sind, die ausgelegt ist, um den Impedanzwandler (2) zu sättigen.

2. Bildsensor nach Anspruch 1, **dadurch gekennzeichnet, daß** er wenigstens ein gegen Lichteinfall abgeschirmtes lichtempfindliches Element (1') aufweist.

3. Bildsensor nach Anspruch 1 oder 2, **dadurch gekennzeichnet, daß** das Rückkopplungselement (3) eine logarithmische Strom-Spannungskennlinie hat.

4. Bildsensor nach Anspruch 1, 2 oder 3, **dadurch gekennzeichnet, daß** das Rückkopplungselement die Potentiale an den Anschlüssen des lichtempfindlichen Elements (1) auf einem von der vom lichtempfindlichen Element (1) empfangenen Beleuchtungsstärke unabhängigen Wert hält.

5. Bildsensor nach einem der vorhergehenden Ansprüche, **dadurch gekennzeichnet, daß** das Rückkopplungselement (3) ein MOS-Transistor ist.

6. Bildsensor nach einem der vorhergehenden Ansprüche, **dadurch gekennzeichnet, daß** das lichtempfindliche Element (1) eine Fotodiode ist.

7. Bildsensor nach einem der vorhergehenden Ansprüche, **dadurch gekennzeichnet, daß** der Impedanzwandler (2) ein Operationsverstärker mit einem mit dem lichtempfindlichen Element (1) verbundenen invertierenden Eingang und einem mit einem Vorspannpotential ($U_{bias}$) verbundenen nichtinvertierenden Eingang ist.

8. Bildsensor nach einem der vorhergehenden Ansprüche, **dadurch gekennzeichnet, daß** sie ein zweites Rückkopplungselement mit linearer Strom-Spannungskennlinie aufweist, das selektiv zwischen den Ausgang des Impedanzwandlers (2) und das lichtempfindliche Element (1) schaltbar ist.

9. Bildsensor nach Anspruch 7, **dadurch gekennzeichnet, daß** er eine Steuerschaltung umfaßt, die eingerichtet ist, um das Vorspannpotential ($U_{bias}$) jeder Bildzelle (20) einzeln vorzugeben.

10. Bildsensor nach einem der vorhergehenden Ansprüche, **gekennzeichnet durch** ein schaltelement (23), das die frei wählbare Adressierung jeder Bildzelle erlaubt.

**Claims**

1. Image sensor having a plurality of optoelectronic image cells, the image cells comprising a light-sensitive element (1; 9), which emits a photocurrent, and an impedance converter (2) for the photocurrent, a respective feedback element (3; 7) being provided between the output of the impedance converter (2) and a connection of the light-sensitive element (1; 9), **characterized in that** the image sensor comprises an image cell (22) having an impedance converter and a feedback element which are connected to a current source (27), said image cell being designed to saturate the impedance converter (2).

2. Image sensor according to Claim 1, **characterized in that** it has at least one light-sensitive element (1') which is screened against the incidence of light.

3. Image sensor according to Claim 1 or 2, **characterized in that** the feedback element (3) has a logarithmic current-voltage characteristic curve.

4. Image sensor according to Claim 1, 2 or 3, **characterized in that** the feedback element keeps the potentials at the connections of the light-sensitive element (1) at a value that is independent of the illumination intensity received by the light-sensitive element (1).

5. Image sensor according to one of the preceding claims, **characterized in that** the feedback element (3) is a MOS transistor.

6. Image sensor according to one of the preceding claims, **characterized in that** the light-sensitive element (1) is a photodiode.

7. Image sensor according to one of the preceding claims, **characterized in that** the impedance converter (2) is an operational amplifier having an inverting input, which is connected to the light-sensitive element (1), and a non-inverting input, which is connected to a bias potential ($U_{bias}$).

8. Image sensor according to one of the preceding claims, **characterized in that** it has a second feedback element which has a linear current-voltage characteristic curve and can be selectively switched between the output of the impedance converter (2) and the light-sensitive element (1).

9. Image sensor according to Claim 7, **characterized in that** it comprises a control circuit which is set up to individually prescribe the bias potential ($U_{bias}$) for each image cell (20).

10. Image sensor according to one of the preceding claims, **characterized by** a switching element (23) which allows each image cell to be addressed in a freely selectable manner.

**Revendications**

1. Capteur d'images comportant une multitude de cellules vidéo optoélectroniques, les cellules vidéo comprenant un élément (1 ; 9) sensible à la lumière délivrant un photocourant et un transformateur d'impédance (2) pour le photocourant, un élément de rétroaction (3 ; 7) étant entre la sortie du transformateur d'impédance (2) et un branchement de l'élément sensible à la lumière (1 ; 9),
**caractérisé en ce que**
le capteur d'images comprend une cellule vidéo (22) renfermant un transformateur d'impédance et un élément de rétroaction branchés sur une source de courant (27) conçue pour saturer le transformateur d'impédance (2).

2. Capteur d'images selon la revendication 1,
**caractérisé en ce qu'**
il présente au moins un élément sensible à la lumière (1') protégé contre la lumière incidente.

3. Capteur d'images selon la revendication 1 ou 2,
**caractérisé en ce que**
l'élément de rétroaction (3) a une ligne caractéristique courant-tension logarithmique.

**4.** Capteur d'images selon la revendication 1, 2 ou 3,
**caractérisé en ce que**
l'élément de rétroaction maintient les potentiels sur des branchements de l'élément sensible à la lumière (1) à une valeur indépendante de l'intensité d'éclairage reçue par celui-ci.

**5.** Capteur d'images selon l'une des revendications précédentes,
**caractérisé en ce que**
l'élément de rétroaction (3) est un transistor MOS.

**6.** Capteur d'images selon l'une des revendications précédentes,
**caractérisé en ce que**
l'élément sensible à la lumière (1) est une photodiode.

**7.** Capteur d'images selon l'une des revendications précédentes,
**caractérisé en ce que**
le transformateur d'impédance (2) est un amplificateur d'opération comportant une entrée inversante reliée à l'élément sensible à la lumière et une entrée non inversante reliée à un potentiel de tension préalable ($U_{bias}$).

**8.** Capteur d'images selon l'une des revendications précédentes,
**caractérisé en ce qu'**
il présente un second élément de rétroaction avec une ligne caractéristique courant-tension linéaire qui peut être commutée sélectivement entre la sortie du transformateur d'impédance (2) et l'élément sensible à la lumière (1).

**9.** Capteur d'images selon la revendication 7,
**caractérisé en ce qu'**
il comporte un circuit de commande équipé pour prédéfinir individuellement le potentiel de tension préalable ($U_{bias}$) de chaque cellule vidéo (20).

**10.** Capteur d'images selon l'une des revendications précédentes,
**caractérisé par**
un élément de commutation (23) qui permet l'adressage librement choisi de chaque cellule vidéo.

Fig. 1

Fig. 2

Fig. 6

Fig. 3

Fig. 5

Fig. 4a

Fig. 4b

# Fig. 7

Fig.8

Fig.9